# EUROPÄISCHE PATENTSCHRIFT

(11) **EP 0 954 880 B1**
(45) Veröffentlichungstag und Bekanntmachung des Hinweises auf die Patenterteilung: **01.12.2004**
(21) Anmeldenummer: 97952723.1
(22) Anmeldetag: 08.12.1997
(51) Int. Cl.: H01L 29/737

(54) **SILIZIUM-GERMANIUM-HETEROBIPOLARTRANSISTOR**
SILICON-GERMANIUM HETERO-BIPOLAR TRANSISTOR
TRANSISTOR HETERO-BIPOLAIRE AU SILICIUM-GERMANIUM

(30) Priorität: 09.12.1996 DE 19652423; 06.12.1997 DE 19755979
(43) Veröffentlichungstag der Anmeldung: 10.11.1999
(73) Patentinhaber: IHP GmbH-Innovations for High Performance Microelectronics/Institut für innovative Mikroelektronik, 15230 Frankfurt (Oder) (DE)
(72) Erfinder: LIPPERT, Gunther, D-15230 Frankfurt an der Oder (DE); OSTEN, Hans-Jörg, D-15299 Müllrose (DE); HEINEMANN, Bernd, D-15234 Frankfurt an der Oder (DE)
(74) Vertreter: Eisenführ, Speiser & Partner
(86) Internationale Anmeldenummer: PCT/DE1997/002908
(87) Internationale Veröffentlichungsnummer: WO 1998/026457

(56) Entgegenhaltungen:
- DE-A- 3 823 249
- US-A- 5 177 025
- US-A- 5 557 118
- LANZEROTTI L D ET AL: "SI/SI1-X-YGEXCY/SI HETEROJUNCTION BIPOLAR TRANSISTORS" IEEE ELECTRON DEVICE LETTERS, Bd. 17, Nr. 7, 1.Juli 1996, Seiten 334-337, XP000595110
- LANZEROTTI L D ET AL: "Suppression of boron outdiffusion in SiGe HBTs by carbon incorporation" INTERNATIONAL ELECTRON DEVICES MEETING. TECHNICAL DIGEST (CAT. NO.96CH35961), INTERNATIONAL ELECTRON DEVICES MEETING. TECHNICAL DIGEST, SAN FRANCISCO, CA, USA, 8-11 DEC. 1996, ISBN 0-7803-3393-4, 1996, NEW YORK, NY, USA, IEEE, USA, Seiten 249-252, XP002062275

## Beschreibung

Die Erfindung bezieht sich auf einen Silizium-Germanium-Heterobipolartransistor.

Neben der Verwendung von Galliumarsenid zur Herstellung von Höchstfrequenztransistoren finden auch Silizium-Germanium-Heterobipolartransistoren in hochfrequenten Bereichen infolge der geringeren Herstellungskosten zunehmend Anwendung. Solche Transistoren bestehen meist aus einer Schichtenfolge Silizium-Kollektorschicht, p-dotierte Silizium-Germanium-Basisschicht und Emitterschicht.

Die deutsche Offenlegungsschrift DE 43 01 333 A1 beschreibt ein Verfahren zur Herstellung integrierter Silizium-Germanium-Heterobipolartransistoren, bei dem eine Kollektorschicht, eine Basisschicht, eine Emitterschicht und eine Emitteranschlußschicht mittels eines einzigen unterbrechungsfreien Prozesses abgeschieden und gleichzeitig dotiert werden. Dieses Verfahren zur Herstellung hochfrequenztauglicher Transistoren hat den Nachteil, daß eine weitere Erhöhung der Dotierung der Basis mit Fremdatomen eine bei entsprechender Temperatur stattfindende Dotandenausdiffusion, d. h. eine Verbreiterung des Basisgebiets zur Folge hätte. Eine Dotandenausdiffusion hat einerseits eine nichtkonstante Transistorfertigung und andererseits eine Verringerung der Kollektor- und Emitterströme zur Folge. Somit ist eine Verbesserung der Hochfrequenzeigenschaften von Transistoren auf diesem Wege nicht möglich. Ebenfalls wird durch die Verbreiterung der dotierten Gebiete eine weitere Strukturverbreiterung begrenzt.

Die japanische Patentanmeldung JP 5 102 177 beinhaltet einen Silizium-Germanium-Heterobipolartransistor, dessen Basis mit 5% Kohlenstoff zur Kompensation der durch Germanium eingebrachten mechanischen Spannungen versetzt ist. Solche hohen Kohlenstoffkonzentrationen führen jedoch zu einer starken lokalen Gitterdeformation, die unter anderem die HF-Tauglichkeit der Transistoren einschränkt.

In der Patentschrift US 5,378,901 ist ein Siliziumkarbidtransistor offenbart, bei dem als Basis-, Kollektor- und Emittermaterial Siliziumkarbid verwendet wird. Die hohen Herstellungstemperaturen verhindern die Integration in hochfrequenztaugliche Schaltungen.

Aus der den nächstliegenden Stand der Technik bildenden Schrift L. D. Lanzerotti et al. "Si/Si_{a-x-y}GeₓC_{y}/Si Heterojunction Bipolar Transistors", IEEE Electron Devices Letters, Vol. 17, No. 7, 334 -337, ist ein Heterobipolartransistor bekannt, der in einer Si_{0,739}Ge_{0,25}C_{0,0011}-Basisschicht sowie benachbarten, undotierten SiGeC Zwischenschichten eine Kohlenstoffkonzentration von 1,1 % aufweist. Die Bor-dotierte Basisschicht hat eine Breite von 46 nm, die undotierten Zwischenschichten ("Spacer layers") auf beiden Seiten der dotierten Basisschicht sind 7 nm dick. Den Emitter bildet eine 60 nm dicke dotierte Siliziumschicht oberhalb einer Zwischenschicht. Weiterhin ist ein 600 nm dicker; schwach n-dotierter Silizium-Kollektor unterhalb der anderen Zwischenschicht vorgesehen.

Aufgabe der Erfindung ist es, einen Silizium-Germanium-Heterobipolartransistor vorzuschlagen, bei dem die Ausdiffusion des Dotanden des Basisgebiets in den Kollektor und in den Emitter reduziert ist und der eine besonders hohe Transitfrequenz sowie eine besonders hohe maximale Schwingungsfrequenz besitzt.

Die Erfindung verfolgt das Ziel, die Borausdiffusion aus der Silizium-Germanium-Schicht aufgrund punktdefektgestützter Diffusionsbeschleunigung zu unterbinden, um im Skalierungsbereich von 0,4 µm Stegbreite und kleiner, HF-Eigenschaften ohne Verluste zu erhalten. Dadurch sollen im Vergleich zu größeren Emitterflächen gleiche Transit- und maximale Schwingfrequenzen erreicht werden.

Diese Aufgabenstellung wird erfindungsgemäß durch einen Heterobipolartransistor nach Anspruch 1 gelöst. Vorteilhafte Ausführungsformen sind in den Unteransprüchen angegeben.

Auf eine reine Siliziumoberfläche findet eine einkristalline Abscheidung entsprechend dem gewünschten Transistorprofil statt. Der erfindungsgemäße Silizium-Germanium-Heterobipolartransistor enthält in den drei Einzelschichten des Transistors, nämlich der Emitterschicht, der Basisschicht und der Kollektorschicht, in einer Konzentration zwischen 10¹⁸ cm⁻³ und 10²¹ cm⁻³ ein zusätzliches, elektrisch nicht aktives Material, nämlich Kohlenstoff.

Hergestellt wird die Halbleiteranordnung von Silizium-Germanium-Heterobipolartransistoren mittels Epitaxieverfahren, z. B. durch Gasphasenepitaxie oder Molekularstrahlepitaxie. Durch die der Epitaxie nachfolgenden technologischen Verfahrensschritte kommt es zu Defekten, z. B. Zwischengitteratomen im Halbleiterkristall, die eine Diffusion von Gitterfremdatomen, z. B. Dotanden, begünstigen.

Ein die Epitaxieschicht eingebrachtes, elektrisch nicht aktives Material, nämlich Kohlenstoff, bindet diese Defekte und verringert die Diffusion des Dotanden. Die durch das Einbringen von Kohlenstoff hervorgerufene Gitteränderung ist dabei kleiner als 5·10⁻³. Die Ausdiffusion des Dotanden verringert sich, was eine Verbreiterung des Basisgebiets einschränkt.

Damit lassen sich hochfrequenztaugliche Transistoren auf zwei Wegen herstellen: Die Dotierungsdosis des Basisgebiets wird erhöht und/oder die Basisbreite wird verringert. In jedem der möglichen Fälle erhöht sich die Konzentration des Dotanden im Basisgebiet des Transistors auf einen Wert zwischen 5·10¹⁸ cm⁻³ und 10²¹ cm⁻³ bei Verwendung von Bor als Dotand. Damit verringert sich der Widerstand der inneren Basis.

Ausgangspunkt für die Herstellung des erfindungsgemäßen Heterobipolartransistors ist die übliche Herstellung eines vorbehandelten Silizium-Substrats. Das Verfahren ist durch folgende Verfahrensschritte gekennzeichnet: Zuerst wird Silizium zur Herstellung der Kollektorschicht aufgedampft. Anschließend wird beim weiteren Siliziumaufdampfen zusätzlich Germanium eingebracht und mittels Gitterfremdatomen dotiert. Als Dotand findet vorzugsweise Bor Verwendung. Durch diesen Verfahrensschritt wird die Basis hergestellt.

Nach dem Abschalten des Zuflusses von Germanium und dem Dotierstoff wird die Emitterschicht durch weiteres Aufdampfen von Silizium hergestellt.

Während der bisher aufgeführten Verfahrensschritte wird ein elektrisch nicht aktives Material, nämlich Kohlenstoff, in einer Konzentration zwischen 10¹⁸ cm⁻³ und 10²¹ cm⁻³ während der Herstellung der epitaktischen Schicht hinzugefügt, wobei die dadurch eingebrachte Gitteränderung kleiner als 5·10⁻³ infolge der geringen Konzentration des elektrisch nicht aktiven Materials ist. Geringe zusätzliche Gitterverspannung bedeutet keine zusätzliche Quelle von möglichen Gitterdefekten. Zur Herstellung der epitaktischen Schicht finden CVD-Verfahren oder MBE-Verfahren Anwendung. Nach der Epitaxie findet die übliche Weiterprozessierung bis zur Herstellung des endgültigen erfindungsgemäßen Silizium-Germanium-Heterobipolartransistors statt.

Das Produkt aus Germaniumkonzentration in der Basisschicht und Breite der Basisschicht von Kollektor bis Emitter beträgt bei einem Ausführungsbeispiel des erfindungsgemäße Silizium-Germanium-Heterobipolartransistors zwischen 50 Atomprozent nm und 2000 Atomprozent nm.

Die Breite der Basisschicht von Kollektor bis Emitter liegt bei einem anderen Ausführungsbeispiel etwa zwischen 5 nm und 60 nm, vorzugsweise zwischen 35 nm und 40 nm.

Die Konzentration des Germaniums in der Basisschicht liegt etwa zwischen 8% und 30%, vorzugsweise zwischen 20% und 28%.

Ausführungsbeispiele der Erfindung sind in den Zeichnungen dargestellt und werden im folgenden näher erläutert. In den Zeichnungen zeigen:
- Fig. 1: schematischer Schichtaufbau eines Silizium-Germanium-Heterobipolartransistors
- Fig. 2: Stufen des Verfahrens zur Herstellung der epitaktischen Einzelschichten für einen Silizium-Germanium-Heterobipolartansistor
- Fig. 3: schematischer Schnitt durch einen Silizium-Germanium-Heterobipolartransistor
- Fig. 4, 5, 6: Konzentrationsverläufe von Germanium in Silizium-Gerrnanium-Heterobipolartransistoren

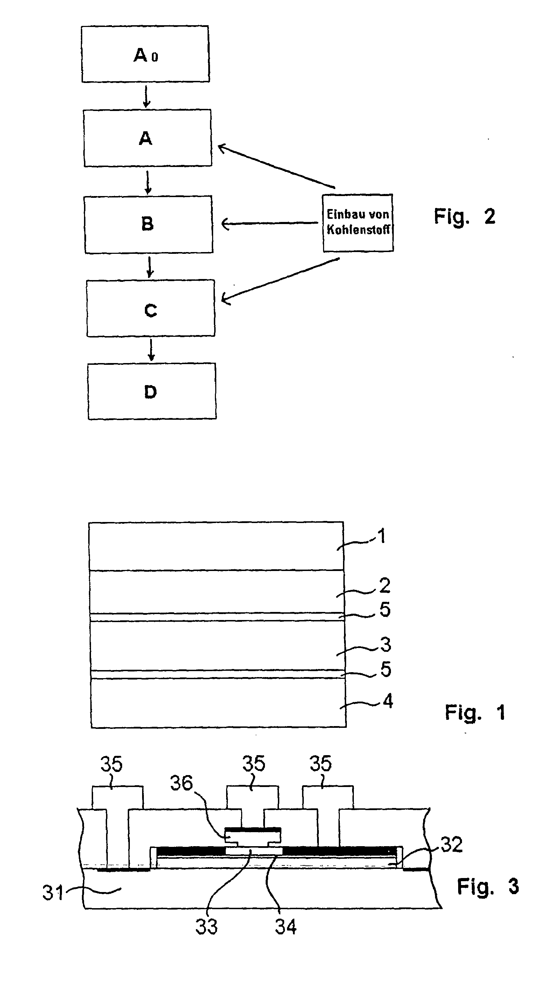

In Fig. 1 ist der Schichtaufbau eines erfindungsgemäßen Silizium-Germanium-Heterobipolartransistors, bestehend aus einem dotierten Silizium-Substrat 1, einer undotierten Silizium-Kohlenstoff-Kollektorschicht **2**, einer dotierten Silizium-Germanium-Kohlenstoff-Basisschicht **3** und einer undotierten Silizium-Kohlenstoff-Emitterschicht **4**, dargestellt. Der gesamte Schichtaufbau des Transistors inklusive Dotierung des Basisgebiets mit Bor wird mittels Molekularstrahlepitaxie hergestellt.

Gleichzeitig wird bei der Epitaxie - in diesem Ausführungsbeispiel - während der Herstellung aller drei Einzelschichten, der Kollektorschicht, der Basisschicht und der Emitterschicht, Kohlenstoff in einer Konzentration zwischen 10¹⁸ cm⁻³ und 10²¹ cm⁻³ zugegeben. Dies entspricht einer Kohlenstoffkonzentration zwischen 0,0015% und 1,5%. Dadurch wird eine mögliche Bordiffusion signifikant verringert, so daß die Dotandenausdiffusionsgebiete 5 im Vergleich zu herkömmlichen Transistoren dieses Typs verkleinert werden. Durch erfindungsgemäße Einfügung von Kohlenstoff verringert sich die Diffusionslänge von Bor um mehr als 50% gegenüber der Diffusionslänge, die ohne Hinzufügung von Kohlenstoff auftritt. Es kommt zur Ausbildung eines sehr steilen Borprofiles. Die dadurch verringerte Basisweite hat eine geringere Basislaufzeit zur Folge. Dies ist gleichbedeutend mit einer Erhöhung der Transitfrequenz und der Erhöhung der maximalen Schwingfrequenz bzw. einem verringerten Rauschmaß des erfindungsgemäßen Transistors.

Eine weitere Verbesserung der Hochfrequenztauglichkeit erfindungsgemäßen Silizium-Germanium-Heterobipolartransistors wird durch Erhöhung der Borkonzentration zwischen 5·10¹⁸ cm⁻³ und 10²¹ cm⁻³ in der Basisschicht 3 erreicht.

Zur Herstellung eines solchen Silizium-Germanium-Heterobipolartransistors werden folgende in Fig. 2 dargestellte Verfahrensschritte durchgeführt: Vor dem erfindungsgemäßen Teil des Verfahrens wird ein vorbehandeltes Silizium-Substrat in einem Verfahrensschritt A₀ üblicherweise hergestellt. Daran schließen sich die Schritte
**A** Siliziumaufdampfen zur Herstellung der Kollektorschicht,
**B** Siliziumaufdampfen und zusätzliches Einbringen von Germanium und Dotanden zur Herstellung der Basisschicht und
C Abschalten von Germanium und Dotierstoff und Siliziumaufdampfen zur Herstellung der Emitterschicht
an, wobei während der Verfahrensschritte **A** bis **C** Kohlenstoff in einer Konzentration zwischen 10¹⁸ cm⁻³ und 10²¹ cm⁻³ eingebaut wird und die dadurch eingebrachte Gitteränderung kleiner als 5·10⁻³ ist.
Nach der Epitaxie findet eine übliche Weiterprozessierung **D** statt bis zur Herstellung eines erfindungsgemäßen Silizium-Germanium-Heterobipolartransistors.

Fig. 3 zeigt einen schematischen Schnitt durch einen derart hergestellten Silizium-Germanium-Heterobipolartransistor. Auf einem hochdotierten Subtrat **31** aus Silizium sind durch Epitaxie der undotierte Silizium-Kohlenstoff-Kollektor **32,** der undotierte Silizium-Kohlenstoff-Emitter **33** und die mit Bor in einer Konzentration zwischen 5·10¹⁸ cm⁻³ und 10²¹ cm⁻³ dotierte Basis **34** aus Silizium, Germanium und Kohlenstoff aufgewachsen. Weiterhin beinhaltet die Figur die entsprechenden Kontaktgebiete **35** sowie ein Implantgebiet **36**. Die Konzentration des Kohlenstoffs in der epitaktischen Schicht beträgt zwischen 10¹⁸ cm⁻³ und 10²¹ cm⁻³.

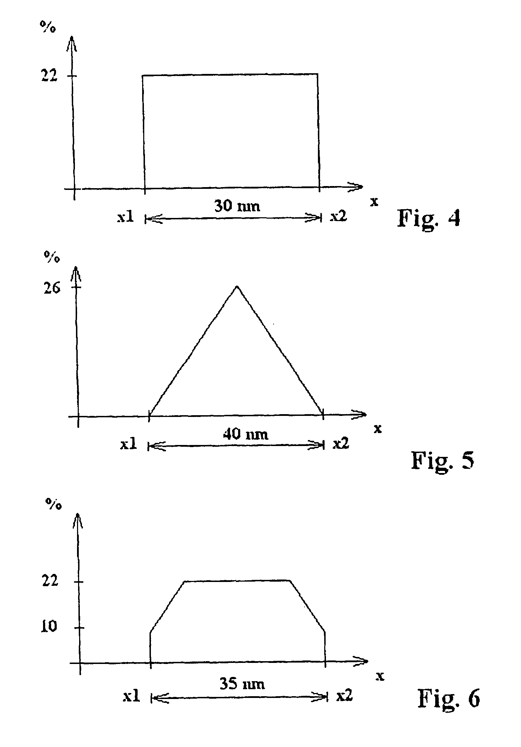

Die Figuren 4 bis 6 zeigen Konzentrationsverläufe von Germanium im Silizium erfindungsgemäßer Silizium-Germanium-Heterobipolartransistoren. Die Verläufe haben eine rechteckige, dreieckige oder trapezartige Form. In allen Diagrammen ist auf der Abszisse der Basisbereich durch die Werte **x1** und **x2** begrenzt. Die Ordinate stellt den prozentualen Verlauf der Konzentration des Germaniums dar.

Beim Transistor mit rechteckförmigem Germaniumkonzentrationsverlauf nach Fig. 4 beträgt die Breite der Basisschicht 30 nm. Die Konzentration des Germaniums in der Basisschicht beträgt etwa konstant 22%. Durch dieses Transistorprofil werden bevorzugt hohe Stromverstärkungen und gute dynamische Eigenschaften erreicht.

Beim Transistor mit dreieckförmigem Germaniumkonzentrationsverlauf nach Fig. 5 beträgt die Breite der Basisschicht 40 nm. Die Konzentration des Germaniums in der Basisschicht beträgt in der Mitte der Basisschicht, wo sie ihren Maximalwert erreicht, etwa 26%. Dieses Transistorprofil ermöglicht die Einstellung sehr hoher Early-Spannungen. Des weiteren gestattet dieses Transistorprofil die Einprägung eines Driftfeldes, um die Basislaufzeit der Minoritätsträger zu verringern.

Beim Transistor mit trapezförmigem Germaniumkonzentrationsverlauf nach Fig. 6 beträgt die Breite der Basisschicht 35 nm. Die Konzentration des Germaniums in der Basisschicht steigt von der Kollektor- bzw. Emitterseite des Transistor linear von etwa 10% auf 22% an. In diesem Ausführungsbeispiel werden durch das Transistorprofil sowohl eine hohe Stromverstärkung als auch eine hohe Early-Spannung, verbunden mit einem Driftfeld, zur Verringerung der Basislaufzeit erreicht.

Bei zunehmender Skalierung wird eine Verbreiterung der Kontaktgebiete durch die Verhinderung der Borausdiffusion durch Kohlenstoff unterbunden, so daß im Skalierungsbereich von 0,4 µm Stegbreite und kleiner HF-Eigenschaften ohne Verluste erhalten bleiben. Auch bei hier geringen Strömen werden im Vergleich zu größeren Strukturen gleiche Transit- und Maximalfrequenzen erreicht.

## Patentansprüche

1. Heterobipolartransistor mit einer Silizium-Kollektorschicht, einer dotierten Silizium-Germanium-Basisschicht und einer Silizium-Emitterschicht, wobei Kohlenstoff während des Herstellung aller drei Einzelschichten, nämlich der Kollektorschicht, der Basisschicht und der Emitterschicht in einer Konzentration zwischen 10¹⁸ cm⁻³ und 10²¹ cm⁻³ zugegeben wird und die dadurch hervorgerufene Gitteränderung jeweils geringer ist als 0,005.

2. Heterobipolartransistor nach Anspruch 1, bei dem das Produkt aus Germaniumkonzentration in der Basisschicht und der Breite der Basisschicht von Kollektor bis Emitter im Bereich zwischen 50 Atom-% *nm und 2000 Atom-% *nm liegt.

3. Heterobipolartransistor nach Anspruch 1 oder 2, bei dem die Konzentration von Germanium in der Basisschicht zwischen 8 Atom-% und 30 Atom-% liegt.

4. Heterobipolartransistor nach einem der vorstehenden Ansprüche; bei dem die Konzentration von Germanium in der Basisschicht zwischen 20 Atom-% und 28 Atom-% liegt.

5. Heterobipolartransistor nach einem der vorstehenden Ansprüche, bei dem die Breite der Basisschicht von Kollektor bis Emitter zwischen 5 nm und 60 nm liegt.

6. Heterobipolartransistor nach Anspruch 5, bei dem die Breite der Basisschicht von Kollektor bis Emitter zwischen 35 nm und 40 nm liegt.

7. Heterobipolartransistor nach einem der vorstehenden Ansprüche, bei dem der Konzentrationsverlauf von Germanium in der Basisschicht die Form eines Rechtecks hat.

8. Heterobipolartransistor nach Anspruch 7, bei dem das Produkt der Germaniumkonzentration in der Basisschicht und der Breite der Basisschicht zwischen Kollektor und Emitter 660 Atom-%*nm beträgt, wobei die Breite der Basisschicht 30 nm und die Germaniumkonzentration 22 Atom-% beträgt.

9. Heterobipolartransistor nach einem der Ansprüche 1 bis 6, bei dem der Konzentrationsverlauf von Germanium in der Basisschicht die Form eines Dreiecks hat.

10. Heterobipolartransistor nach Anspruch 9, bei dem das Produkt der Germaniumkonzentration in der Basisschicht und der Breite der Basisschicht zwischen der Kollektorschicht und der Emitterschicht 520 Atom-%*nm beträgt, wobei die Breite der Basisschicht 40 nm beträgt und das Dreiecksprofil in der Mitte der Basisschicht eine maximale Germaniumkonzentration von 26 Atom-% erreicht.

11. Heterobipolartransistor nach einem der Ansprüche 1 bis 6, bei dem der Konzentrationsverlauf von Germanium in der Basisschicht die Form eines Trapezes hat.

## Claims

1. Hetero-bipolar transistor comprising a silicon collector layer, a doped silicon-germanium base layer and a silicon emitter layer, wherein during production of all three individual layers, namely the collector layer, the base layer and the emitter layer, carbon is added in a concentration between 10¹⁸ cm⁻³ and 10²¹ cm⁻³ and the change in the lattice caused thereby is less than 0.005 in each case.

2. Hetero-bipolar transistor according to claim 1, wherein the product of the germanium concentration in the base layer and the width of the base layer from collector to emitter is in the range between 50 atom %*nm and 2000 atom %*nm.

3. Hetero-bipolar transistor according to either claim 1 or claim 2, wherein the concentration of germanium in the base layer is between 8 atom % and 30 atom %.

4. Hetero-bipolar transistor according any one of the preceding claims, wherein the concentration of germanium in the base layer is between 20 atom % and 28 atom %.

5. Hetero-bipolar transistor according any one of the preceding claims, wherein the width of the base layer from collector to emitter is between 5 nm and 60 nm.

6. Hetero-bipolar transistor according to claim 5, wherein the width of the base layer from collector to emitter is between 35 nm and 40 nm.

7. Hetero-bipolar transistor according to any one of the preceding claims, wherein the concentration characteristic of germanium in the base layer has the shape of a rectangle.

8. Hetero-bipolar transistor according to claim 7, wherein the product of the germanium concentration in the base layer and the width of the base layer between the collector and the emitter is 660 atom % *nm, the width of the base layer being 30 nm and the germanium concentration being 22 atom %,

9. Hetero-bipolar transistor according to any one of claims 1 to 6, wherein the concentration characteristic of germanium in the base layer has the shape of a triangle.

10. Hetero-bipolar transistor according to claim 9, wherein the product of the germanium concentration in the base layer and the width of the base layer between the collector layer and the emitter layer is 520 atom %*nm, the width of the base layer being 40 nm and the triangular profile in the centre of the base layer attaining a maximum germanium concentration of 26 atom %.

11. Hetero-bipolar transistor according to any one of claims 1 to 6, wherein the concentration characteristic of germanium in the base layer has the shape of a trapezium.

## Revendications

1. Transistor hétéro-bipolaire comportant une couche formant collecteur en silicium, une couche de base en silicium-germanium dopée et une couche d'émetteur en silicium, du carbone étant ajouté pendant la fabrication de l'ensemble des trois couches individuelles, à savoir à la couche de collecteur, à la couche de base et à la couche d'émetteur en une concentration comprise entre 10¹⁸ cm⁻³ et 10²¹ cm⁻³, et la modification provoquée de réseau est respectivement inférieure à 0,005.

2. Transistor hétéro-bipolaire selon la revendication 1, dans lequel le produit de la concentration du germanium dans la couche de base par la largeur de la couche de base du collecteur à l'émetteur est situé dans la gamme comprise entre 50 % atomiques*nm et 2000 % atomiques*nm.

3. Transistor hétéro-bipolaire selon la revendication 1 ou 2, dans lequel la concentration de germanium dans la couche de base est située entre 8 % atomiques et 30 % atomiques.

4. Transistor hétéro-bipolaire selon l'une des revendications précédentes, dans lequel la concentration de germanium dans la couche de base se situe entre 20 % atomiques et 28 % atomiques.

5. Transistor hétéro-bipolaire selon l'une des revendications précédentes, dans lequel la largeur de la couche de base du collecteur à l'émetteur se situe entre 5 nm et 60 nm.

6. Transistor hétéro-bipolaire selon la revendication 5, dans lequel la largeur de la couche de base du collecteur à l'émetteur se situe entre 35 nm et 40 nm.

7. Transistor hétéro-bipolaire selon l'une des revendications précédentes, dans lequel l'allure de la concentration du germanium dans la couche de base possède la forme d'un rectangle.

8. Transistor hétéro-bipolaire selon la revendication 7, dans lequel le produit de la concentration de germanium dans la couche de base par la largeur de la couche de base entre le collecteur et l'émetteur est égal à 660 % atomiques*nm, la largeur de la couche de base étant égale à 30 nm et la concentration en germanium étant égale à 22 % atomiques.

9. Transistor hétéro-bipolaire selon l'une des revendications 1 à 6, dans lequel l'allure de la concentration du germanium dans la couche de base possède la forme d'un triangle.

10. Transistor hétéro-bipolaire selon la revendication 9, dans lequel le produit de la concentration en germanium dans la couche de base par la largeur de la couche de base entre la couche de collecteur et la couche d'émetteur est égal à 520 % atomiques*nm, la largeur de la couche de base étant égale à 40 nm et le profil triangulaire au centre de la couche de base atteignant une concentration maximale de germanium de 26 % atomiques.

11. Transistor hétéro-bipolaire selon l'une des revendications 1 à 6, dans lequel l'allure de la concentration du germanium dans la couche de base possède la forme d'un trapèze.
